# EUROPÄISCHE PATENTANMELDUNG

(11) **EP 1 424 884 A1**
(43) Veröffentlichungstag der Anmeldung: **02.06.2004**
(21) Anmeldenummer: 02026650.8
(22) Anmeldetag: 29.11.2002
(51) Int. Cl.: H05K 13/04

(54) **Verfahren zur Montage miniaturisierter Bauteile auf einer Trägerplatte**

(71) Anmelder: Leica Geosystems AG, 9435 Heerbrugg (CH)
(72) Erfinder: Wuersch, Alain, 1814 La Tour -de-Peilz (CH); Rossopoulos, Stephane, 1412 Ursins (CH); Verettas, Irène, 1007 Lausanne (CH); Clavel, Reymond, 1377 Oulens/ Echallens (CH)
(74) Vertreter: Kaminski, Susanne, Dr.

(57) **Zusammenfassung**

Die Erfindung betrifft ein Verfahren zum Fixieren eines miniaturisierten, zur Aufnahme eines optischen Elements vorgesehenen Bauteils (2) auf einer Trägerplatte mittels Löten, Kleben oder Schweißen, wobei das Bauteil (2) von einem Greifer (1) eines Roboterarms gehalten und die Schrumpfung beim Erstarren der Verbindungsnaht zwischen dem Bauteil (2) und der Trägerplatte durch eine gesteuerte bzw. geregelte vertikale Bewegung des Greifers (1) kompensiert wird. Zur Regelung der Bewegung kann der Greifer (1) mit einem Positionssensor (5) oder einem Kraftsensor (4) ausgestattet werden, oder die Bewegung wird automatisiert nach einem Algorithmus auf der Basis der Materialeigenschaften der Verbindungsnaht gesteuert.

## Beschreibung

### Technisches Gebiet

Die Erfindung betrifft ein Verfahren für und Greifer von Robotermontagestationen zum Fixieren eines miniaturisierten Bauteils auf einer Trägerplatte durch eine Löt-, Schweiß- oder Klebeverbindung, die insbesondere zur Feinadjustierung von Bauteilen, die optische Elemente enthalten, geeignet sind.

### Hintergrund der Erfindung

Auf dem Gebiet der Mikro-Montagetechnologie, in der automatisierte Robotermontagestationen eingesetzt werden, können Bauteile mit einer Genauigkeit, die nahezu an die Positionierungsauflösung des Greifers (generell unter 1 Mikron) heranreicht, auf einer Trägerplatte positioniert werden. Jedoch wird die Positionierungsgenauigkeit oft während des Verbindens des Bauteils mit der Trägerplatte durch Löten, Kleben oder Schweißen herabgesetzt. Ein Grund hierfür ist das Auftreten einer insbesondere vertikalen Schrumpfung der Verbindungsnaht zwischen dem Bauteil und der Trägerplatte während des Abkühlens des Lots beim Löten bzw. der Schweißnaht beim Schweißen oder des Aushärtens des Klebstoffs. Da das Bauteil vom Greifer fest gehalten wird, löst die Schrumpfung der Verbindungsnaht und die durch das Abkühlen der gesamten Halterung hervorgerufene Schrumpfung Spannungen bzw. Zugkräfte zwischen dem Bauteil und der Trägerplatte aus, die freigesetzt werden, sobald das Bauteil vom Greifer losgelassen wird, und die zu einer unerwünschten Depostionierung des Bauteils führen, wodurch die Endgenauigkeit der Fixierung des Bauteils herabgesetzt wird.

Den Stand der Technik zeigt WO 00/28367. Hier wird ein Greifer beschrieben, dessen Höhenposition während des Abkühlens bzw. Aushärtens der Verbindungsnaht nachgibt, bis eine Sollspannung, vorgegeben durch eine Feder, erreicht wird. Bei diesem passiven Verfahren ist diese Höhenposition, die nicht aktiv verstellt wird, somit abhängig von der inneren Spannung der Verbindungsnaht während des Abkühl- bzw. Aushärteprozesses, die wiederum abhängig von der Dicke der Löt- bzw. Schweiß- oder Klebschicht ist. Die Dicke dieser Schicht variiert jedoch aufgrund von Toleranzen, weshalb die Endposition des Bauteils stark vom Zufall abhängig ist. Eine hohe Genauigkeit ist hier somit nur unter idealen Verfahrensbedingungen erzielbar.

Somit besteht auf dem Gebiet der Mikro-Technologie weiterhin ein Bedarf für eine Verbesserung der Positionierungsgenauigkeit von miniaturisierten Bauteilen, da allein durch die oben beschriebene passive Höhenpositionsverstellung die durch die Schrumpfung erzeugte Spannung im System, das insbesondere aus dem Bauteil, der Verbindungsnaht, der Trägerplatte und der gesamten Halterung besteht, nicht vollständig ausgeglichen wird.

### Kurze Darstellung der Erfindung

Der Erfindung liegt die Aufgabe zugrunde, die Endgenauigkeit der Montage miniaturisierter Bauteile durch Vermeiden von ungewollten Positionsverschiebungen des Bauteils während des Schrumpfens oder beim Lösen des Greifers nach dem Fixieren zu verbessern.

Die Aufgabe wird durch die in den Patentansprüchen gekennzeichneten Ausführungsformen gelöst.

Erfindungsgemäß wird zum Fixieren eines miniaturisierten Bauteils auf einer Trägerplatte das Bauteil mit einem Greifer einer Roboterstation gefasst, festgehalten und über der Trägerplatte relativ zu äußeren Bezugspunkten positioniert. Anschließend wird eine Verbindung zwischen dem Bauteil und der Trägerplatte durch Löten, Kleben oder Schweißen hergestellt. Das Erstarren der Löt- bzw. Klebemasse oder der Schweißnaht geht mit einer Schrumpfung der Verbindungsnaht zwischen dem Bauteil und der Trägerplatte einher, wobei gleichzeitig mit der Schrumpfung der Greifer eine gesteuerte bzw. geregelte vertikale Bewegung in Richtung der Trägerplatte bis zu einer definierten Sollposition ausführt und damit die Schrumpfung gegebenenfalls kontinuierlich kompensiert. Dabei wird die innere Spannung weitgehend abgebaut, so dass die eventuell verbleibende Restspannung beim Lösen des Bauteils vom Greifer keine Positionsänderung mehr auslöst.

Bei der Lösung geht die Erfindung von dem Grundgedanken aus, mit der gesteuerten bzw. geregelten Bewegung des Greifers die aufgrund der Schrumpfung auftretende Spannung bzw. Zugkraft zwischen dem Bauteil und der Trägerplatte auszugleichen, bis die definierte Sollposition erreicht ist, um eine unerwünschte Depositionierung des Bauteils während der Schrumpfung und/oder beim Lösen vom Greifer zu vermeiden.

Die Bewegung des Greifers kann beispielsweise gesteuert und/oder geregelt werden durch Messen der Kraft, die auf den Greifer als Folge der erstarrenden Verbindungsnaht ausgeübt wird, durch Messen der vertikalen Positionsverschiebung des Greifers während des Schrumpfens oder durch eine automatische Sequenz, die einem Algorithmus folgt, der aufgrund der Materialeigenschaften und dem daraus ergebenden Schrumpfungsverhalten gewählt wird.

Ein Vorteil der genannten Maßnahmen ist, dass durch das Ausgleichen der Spannung bzw. Zugkraft während des Schrumpfens die Endgenauigkeit der Montage der Bauteile wesentlich erhöht wird.

Die Erfindung betrifft außerdem Greifvorrichtungen von Robotermontagestationen, die mit Kraft- und/oder Positionssensoren ausgestattet sind. Durch diese Sensoren können nicht nur die innere Spannung an der Verbindungsnaht und/oder die Position des Greifers während des Schrumpfens bestimmt, sondern auch die Bewegung des Greifers während des Schrumpfens geregelt werden.

Das erfindungsgemäße Verfahren und die Greifvorrichtung eignen sich insbesondere für die Montage von miniaturisierten Bauteilen, auch Mikro-Komponenten genannt, die optische Elemente wie beispielsweise Linsen, optische Fasern, Dioden, etc., enthalten.

### Kurze Beschreibung der Zeichnungen

- Fig. 1: zeigt eine schematische Darstellung eines Greifers mit einem Kraftsensor;
- Fig. 2: zeigt eine schematische Darstellung eines Greifers mit einem Positionsdetektor
- Fig. 3: zeigt eine konkrete Ausführungsform des in Fig. 2 schematisch dargestellten Greifers

### Detaillierte Beschreibung der Erfindung

Das erfindungsgemäße Verfahren wird in automatischen Robotermontagestationen verwendet, da alle erforderlichen Aufgaben durch Roboter ausgeführt werden können, die mit Positionierungssensoren versehen sind. Jedes Bauteil wird im Raum durch einen Roboter entlang den sechs Freiheitsgraden positioniert und festgelegt. Ein Beispiel für ein Verfahren zur Befestigung eines insbesondere modular gefassten, miniaturisierten Bauteils auf einer Trägerplatte durch beispielsweise eine Lötverbindung ist in der WO 99/26754 beschrieben. Weitere Verbindungsmethoden sind Schweißen, wie zum Beispiel Laserpunktschweißen oder elektrisches Widerstandspunktschweißen, oder Kleben.

Die Endgenauigkeit hängt direkt von der Wiederholbarkeit des Schrumpfens ab. Während der Abkühlungsphase beim Löten und Schweißen bzw. der Aushärtung beim Kleben ändert die Schrumpfung an der Verbindungsnaht zwischen dem Bauteil und der Trägerplatte unvermeidbar die Bauteileinstellung entlang der vertikalen Achse. Die Schrumpfung zeigt eine sehr gute Wiederholbarkeit und kann als Funktion des Zwischenraums zwischen der Trägerplatte und der Bauteilbasis kalibriert werden. Eine gute Befestigungsgenauigkeit kann nur erreicht werden, wenn das Schrumpfen im voraus ausgeglichen worden ist, bevor das Löt-, Klebe- oder Schweißverfahren beginnt. D.h. zum Beispiel, die Größe der Schrumpfung bei der vertikalen Ausrichtung des Bauteils über der Trägerplatte bereits vorab zu berücksichtigen. Ist die Basis des Bauteils mit einer sphärischen oder zylindrischen Symmetrie ausgestattet, werden die seitliche Genauigkeit und die Winkelgenauigkeit durch die Schrumpfung nicht geändert.

Das Bauteil wird während der Fixierung von einem Greifer der Roboterstation festgehalten, wobei der Greifer in vertikaler Richtung, d.h. lotrecht zur Trägerplatte, durch die Roboterstation steuerbar beweglich ist. Hierzu ist der Greifer an einer Halterung oder einem Arm der Roboterstation befestigt, welche zumindest in vertikaler Richtung zur Trägerplatte absenkbar und gegebenenfalls entlang aller 6 Freiheitsgrade beweglich sind. Sobald die Schrumpfung einsetzt, wird der Greifer gesteuert und/oder geregelt vertikal zu Trägerplatte im Ausmaß der Schrumpfung bewegt, um diese zu kompensieren, bis die Sollposition erreicht ist. Es ist bevorzugt, dass die Schrumpfung kontinuierlich kompensiert wird. Wesentlich ist, dass die Kompensation der Schrumpfung durch die vertikale Bewegung des Greifers in Richtung der Trägerplatte derart fein gesteuert und/oder geregelt wird, dass ein Auftreten von Spannungen, Zug- und/oder Zerrkräften im System aus Bauteil, Verbindungsnaht, Trägerplatte und Halterung weitgehend vermieden wird und die Sollposition erreicht wird.

Aufgrund der Wiederholbarkeit der Schrumpfung kann das Schrumpfungsverhalten der eingesetzten Materialien vorab experimentell oder durch Simulation bestimmt, mit den dabei ermittelten Daten ein Algorithmus festgelegt und damit eine automatische Sequenz in der Roboterstation implementiert werden, durch die dann die Bewegung des Greifers während der Schrumpfung gesteuert wird.

In einer weiteren Ausführungsform der Erfindung ist ein Kraftsensor in den Greifer integriert. Sobald eine Verbindungsnaht zwischen dem Bauteil und der Trägerplatte hergestellt ist und die Basis des vom Greifer festgehaltenen Bauteils mit dem noch flüssigen Löt-, Klebe- oder Schweißmedium benetzt ist, wird die Spannung der flüssigen bzw. weichen Verbindungsnaht mit dem Kraftsensor gemessen, bevor die Schrumpfung einsetzt. Der ermittelte Messwert dient dann als Soll-Wert in einem Regelkreis, der die Bewegung des Greifers über ein Rückkopplungssignal regelt, das sich aus der Differenz des Soll-Werts und des während des Schrumpfens gemessenen Messwerts ergibt. Löst die Schrumpfung nun eine Zugkraft in Richtung der Trägerplatte auf das Bauteil aus, wird der Greifer so lange vertikal in Richtung der Trägerplatte bewegt, bis die Zugkraft größtenteils kompensiert, d.h. der Soll-Wert erreicht ist.

In einer anderen Ausführungsform der Erfindung ist der Greifer relativ zur Roboterstation und vertikal gegenüber der Trägerplatte etwas frei beweglich ausgeführt. Diese Freibeweglichkeit kann beispielsweise durch eine Feder, die eine geringe vertikale Bewegung des Greifers erlaubt und über die der Greifer mit der Roboterstation verbunden ist, erreicht werden. In diesem Fall ist der Greifer mit einem Positionsdetektor ausgestattet, der die gegenüber der Roboterstation relative Bewegung misst. Die relative vertikale Position des Greifers wird wiederum gemessen, sobald eine Verbindungsnaht zwischen der Basis des durch den Greifer festgehaltenen Bauteils und der Trägerplatte hergestellt ist, jedoch bevor die Schrumpfung einsetzt. Der ermittelte Messwert, d.h. die relative vertikale Position, fließt dann als Soll-Wert in einen Regelkreis ein, der die vertikale Bewegung des Greifers über ein Rückkopplungssignal aus dem Vergleich des Soll-Werts mit der während der Schrumpfung gemessenen Ist-Position regelt. Wird nun aufgrund der durch die Schrumpfung ausgelösten Zugkraft die vertikale Position des Greifers etwas in die Richtung der Trägerplatte verschoben, so wird diese erzwungene Verschiebung unmittelbar darauf durch einen entsprechenden aktiven, vertikalen Positionsnachjustierung des Greifers durch die Roboterstation wieder ausgeglichen.

Selbstverständlich können auch mit den Regelkreisen, die Kraft- bzw. Positionsdetektoren einsetzen, durch automatische Sequenzen gesteuerte Bewegungen zusätzlich feinadjustiert werden.

Da die Befestigung des Bauteils auf der Trägerplatte durch eine Roboter-Zusammenbaustation durchgeführt wird, wird die Befestigungsgenauigkeit auch durch den Greifer beeinflusst, der an dem Roboterarm angebracht ist. Der Greifer muss das Bauteil erfassen, es relativ zu äußeren Bezugspunkten positionieren, es während dem Löten, Schweißen oder Kleben in seiner Lage halten und es freigeben, nachdem die Befestigung hergestellt worden ist. Aufgrund der kleinen Abmessungen des Bauteils, beispielsweise 2 x 2 x 3 mm, ist es schwierig, dieses gleich bleibend zu ergreifen.

Die notwendige Greifkraft kann auf unterschiedliche Weise bereitgestellt werden, wobei es aber wegen der kleinen Abmessung des Bauteils schwierig ist, eine Kraft mit ausreichender Vorsicht auszuüben. Aufgrund der erhöhten Befestigungsgenauigkeit, die verlangt wird, muss das Bauteil von dem Greifer freigegeben werden, ohne dass seine Position beeinträchtigt wird. Die meisten Lösungen, bei denen die Greifkraft durch eine mechanische Wirkung erzeugt wird, müssen unberücksichtigt bleiben, weil sie während der Freigabephase die Befestigungsgenauigkeit beeinträchtigen können.

Als geeignete Lösung hat sich ein Greifer erwiesen, dessen Haltekraft durch einen Magneten, insbesondere einen Elektromagneten, erzeugt wird.

Nachfolgend wird das erfindungsgemäße Verfahren anhand zweier Beispiele näher beschrieben.

### Beispiel 1 :

Lötbefestigung miniaturisierter Bauteile auf einer Trägerplatte mit Metallbeschichtung und Steuerung der Bewegung des Greifers durch eine automatische Sequenz.

Dieses Verfahrensprinzip ist in der WO 99/26754 beschrieben. Das Bauteil wird an der zu verbindenden Basisseite mit Lötmaterial beschichtet, vom Greifer der Roboterstation gefasst und in seiner Position oberhalb der Trägerplatte so ausgerichtet, dass ein kleiner Spalt für die Lötverbindung und zusätzlich ein Spielraum für die Kompensation der Schrumpfung zwischen der Basis des Bauteils und der Trägerplatte bleibt. Hierzu wird in Vorversuchen das Ausmaß der Schrumpfung bestimmt. Ergeben diese Versuch zum Beispiel eine Amplitude der Schrumpfung von -4.5µm ±0.5, so positioniert die Roboterstation das Bauteil an seiner vertikalen Endposition +4.5µm, d.h die zu erwartende Schrumpfung wird der vertikalen Höhe vor dem Verbinden hinzugerechnet. Anschließend wird mit einem Laser das Lötmaterial an der Basis des Bauteils zum Schmelzen gebracht, so dass sich zwischen der Basis des Bauteils und der Trägerplatte ein Tropfen aus Lötmaterial ausformt, der den Spalt füllt und die Verbindung zwischen den beiden Teilen herstellt.

Nun wird, in Verbesserung dieses Verfahrens, unmittelbar nach Abschalten des Lasers die automatische Sequenz auf Basis eines Algorithmus gestartet, wodurch die nachgebende vertikale Bewegung des Greifers in Richtung Trägerplatte während des Schrumpfens gesteuert wird:

Die Kühlungstemperatur T bildet dabei eine Asymptote, die bei der Fusionstemperatur T_{*f*} startet und sich der Umgebungstemperatur annähert. Die vertikale Schrumpfung *x* ist proportional zur Abkühlung, so dass für die Festlegung der automatischen Sequenz gilt: Δ*x* ≈ α (T_{*f*}-T), wobei α der angenäherte thermische Expansionskoeffizient des Systems ist.

Abhängig von den eingesetzten Materialien dauert die Abkühlphase etwa 2 bis 10 sec., worauf das Bauteil durch den Greifer wieder freigegeben wird.

### Beispiel 2:

Lötbefestigung eines Bauteils auf einer Trägerplatte, wobei die Ausgleichsbewegung des Greifers mit Regelkreisen, die Kraft- oder Positionsdetektoren verwenden, erfolgt.

Im Gegensatz zu dem in der WO 99/26754 beschriebenen Verfahren wird in diesem Beispiel das Lötmaterial direkt auf die Trägerplatte aufgebracht. Nachdem das Bauteil von der Roboterstation berührungsfrei über der Trägerplatte in Position gebracht ist, wird für n Sekunden ein Laser eingeschaltet, um das Lötmaterial zu schmelzen, wobei n<tₘₐₓ und tₘₐₓ = Dauer des Laserimpuls. Das Lötmaterial kann entweder direkt von einem oberhalb der Trägerplatte angeordneten Laser schräg angestrahlt werden oder es wird der Laser unterhalb einer - für Laserstrahlen transparenten und mit einer Metallschicht beschichteten - Trägerplatte angebracht, worauf im letzteren Fall der Laserstrahl die Trägerplatte durchdringt, auf die Metallschicht auftrifft, die Metallschicht erwärmt und dadurch das Lötmaterial zum Schmelzen bringt. Danach wird der Greifer, der mit einem Kraft- oder Positionsdetektor ausgestattet ist, mit dem Bauteil zur Trägerplatte abgesenkt, sodass das geschmolzene Lötmaterial die Basis des Bauteils benetzt, worauf der Greifer samt Bauteil auf eine gegenüber der Trägerplatte vertikale Position angehoben wird, die der festgelegten Endmontageposition plus der zu erwartenden Schrumpfung entspricht. Der Greifer muss die Endposition vor tₘₐₓ erreicht haben. Danach wird der Laser abgeschaltet und der Messwert des Detektors zum Zeitpunkt des Abschaltens gespeichert. Hierauf wird die Folgeregelungssequenz gestartet, während das Lötmaterial abkühlt. Der gespeicherte Detektormesswert wird hierzu als Soll-Wert für die Rückkopplungsschleife zur Regelung der vertikalen Bewegung des Greifers verwendet. Nach dem Erstarren des Lötmaterials wird das Bauteil vom Greifer gelöst.

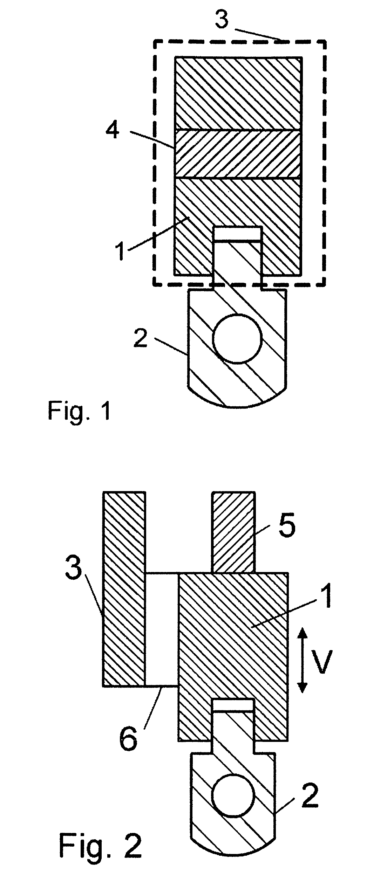

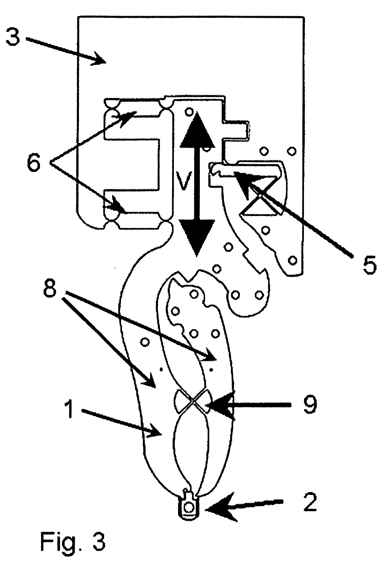

Zwei Ausführungsformen für Greifvorrichtungen mit Messdetektoren sind in den Fig. 1 und 2 schematisch und in Fig. 3 konkret dargestellt.

Fig. 1 zeigt einen Greifer 1 der Robotermontagestation 3, der ein Mikro-Bauteil 2 mit einer sphärisch ausgebildeten Basis festhält. In dem Greifer 1 ist ein vertikaler Kraftsensor 4 integriert.

Fig. 2 zeigt einen Greifer 1, der ein Bauteil 2 mit einer ebenfalls sphärisch ausgebildeten Basis festhält und über Federn 6 von einer Robotermontagestation 3 gehalten wird. Auf dem Greifer 1 ist ein vertikaler Positionsdetektor 5 angebracht, der die relative vertikale Position des Greifers 1 gegenüber der Robotermontagestation 3 misst. Aufgrund der Federn 6 ist der Greifer 1 etwas gegenüber der Robotermontagestation 3 in vertikaler Richtung V beweglich. Beim Herstellen der Lötverbindung zwischen dem Bauteil 2 und der Trägerplatte wird die Basis des Bauteils 2 mit dem geschmolzenen Lötmaterial benetzt. Wenn das Lötmaterial beim Abkühlen schrumpft, wird das Bauteil 2 samt dem Greifer 1 in Schrumpfungsrichtung, d.h. vertikal zur Trägerplatte, nachgezogen. Diese Positionsverschiebung wird vom Positionsdetektor 5 gemessen, worauf ein Rückkopplungssignal an die Robotermontagestation 3 gesendet wird, um die Positionseinstellung des Greifers 1 derart nachzujustieren, so dass die durch die Schrumpfung verursachte vertikale Verschiebung wieder ausgeglichen wird.

Fig. 3 zeigt eine konkrete Ausführungsform des in Fig. 2 schematisch dargestellten und oben beschriebenen Greifers 1, wobei zwei Greiffinger 8 des Greifers 1 durch eine Gelenk 9 miteinander verbunden sind, über das die mittels eines Elektromagneten eingeleitete Greifkraft umgelenkt wird.

## Patentansprüche

1. Verfahren zum Fixieren eines miniaturisierten Bauteils auf einer Trägerplatte durch eine Löt-, Schweiß- oder Klebeverbindung mit den Schritten:
a) Fassen und Festhalten des Bauteils mit einem Greifer einer Roboterstation,
b) Positionieren des Bauteils durch den Greifer über der Trägerplatte relativ zu äußeren Bezugspunkten,
c) Herstellen einer Verbindung des Bauteils mit der Trägerplatte durch Löten, Schweißen oder Kleben, wobei die bei der Herstellung entstehende Verbindungsnaht zwischen dem Bauteil und der Trägerplatte unter Schrumpfung erstarrt und dabei der Greifer durch eine Bewegung in - bezogen auf die Trägerplatte - vertikaler Richtung der Zugkraft der Schrumpfung nachgibt, und
d) Lösen des Greifers vom Bauteil, nachdem die Verbindungsnaht erstarrt ist,
**dadurch gekennzeichnet, dass**
in Schritt c) die Zugkraft der Schrumpfung durch eine gesteuerte oder geregelte Bewegung des Greifers in Richtung der Trägerplatte kompensiert wird.

2. Verfahren nach Patentanspruch 1, wobei die Zugkraft der Schrumpfung im wesentlichen kontinuierlich kompensiert wird.

3. Verfahren nach einem der Patentansprüche 1 oder 2, wobei die Steuerung oder Regelung durch eine automatische Sequenz nach einem Algorithmus erfolgt, der aufgrund der Materialeigenschaften der Verbindungsnaht gewählt wird.

4. Verfahren nach einem der Patentansprüche 1 bis 3, wobei die Bewegung des Greifers sequenziell regelbar ist.

5. Verfahren nach Patentanspruch 4, wobei während des Schritts c) die Spannung an der Verbindungsnaht gemessen wird, als Soll-Wert für die Regelung der Messwert vor dem Einsetzen der Schrumpfung eingestellt wird und die Bewegung des Greifers über ein Rückkopplungssignal aus der Differenz der während der Schrumpfung gemessenen Spannung und dem Soll-Wert geregelt wird.

6. Verfahren nach Patentanspruch 5, wobei die Messung mit einem Kraftsensor erfolgt.

7. Verfahren nach Patentanspruch 4, wobei der Greifer relativ zur Roboterstation und vertikal zur Trägerplatte beweglich ist, die relative vertikale Position des Greifers gegenüber dem Roboterstation während des Schritts c) gemessen wird, als Soll-Wert für die Regelung der Messwert der Position vor dem Einsetzen der Schrumpfung eingestellt wird und die Bewegung des Greifers über ein Rückkopplungssignal aus der Differenz der gemessenen Position während der Schrumpfung mit dem Soll-Wert geregelt wird.

8. Verfahren nach Patentanspruch 7, wobei die relative Position des Greifers gegenüber der Roboterstation mit einem Positionsdetektor gemessen wird.

9. Verwendung eines Verfahrens nach einem der Patentansprüche 1 bis 8 zum Fixieren von Bauteilen, die zur Aufnahme von optischen Elementen vorgesehen sind.

10. Greifer (1) einer Roboterstation (3) zur Verwendung in einem Verfahren nach einem der Patentansprüche 1, 2, 3, 4, 5 oder 6 zum Fassen, Festhalten und Positionieren eines miniaturisierten Bauteils (2) relativ zu äußeren Bezugspunkten über einer Trägerplatte, die für ein Montageverfahren geeignet ist, bei dem das Bauteil (2) auf der Trägerplatte durch Löten, Schweißen oder Kleben fixiert wird, wobei die beim Löten, Schweißen oder Kleben entstehende Verbindungsnaht zwischen dem Bauteil (2) und der Trägerplatte unter Schrumpfung erstarrt, wobei der Greifer (1 ) einen Kraftsensor (4) aufweist.

11. Greifer (1) einer Roboterstation (3) zur Verwendung in einem Verfahren nach einem der Patentansprüche 1, 2, 3, 4, 7 oder 8 zum Fassen, Festhalten und Positionieren eines miniaturisierten Bauteils (2) relativ zu äußeren Bezugspunkten über einer Trägerplatte, die für ein Montageverfahren geeignet ist, bei dem das Bauteil (2) auf der Trägerplatte durch Löten, Schweißen oder Kleben fixiert wird, wobei die beim Löten, Schweißen oder Kleben entstehende Verbindungsnaht zwischen dem Bauteil (2) und der Trägerplatte unter Schrumpfung erstarrt, wobei der Greifer (1 ) relativ zur Roboterstation (3) und vertikal zur Trägerplatte beweglich ist und an dem Greifer (1) ein Positionsdetektor (5) angebracht ist.

12. Greifer (1) nach Patentanspruch 11, wobei der Greifer (1) über zumindest eine elastische Verbindung, gegebenenfalls über eine Feder (6), mit der Roboterstation (3) verbunden ist.

13. Greifer nach einem der Patentansprüche 10 bis 12, wobei ein Magnet zum Festhalten des Bauteils (2) vorgesehen ist.

14. Greifer nach einem der Patentansprüche 10 bis 13, wobei der genannte Greifer über eine Halterung oder einen Roboterarm mit der Roboterstation verbunden ist und die vertikale Beweglichkeit der Halterung oder des Roboterarms relativ zu einer Trägerplatte regelbar ist.

15. Verwendung eines Greifers nach einem der Patentansprüche 10 bis 14 zum Fixieren von Bauteilen, die zur Aufnahme von optischen Elementen vorgesehen sind.
